# EUROPEAN PATENT APPLICATION

(11) **EP 2 434 542 A2**
(43) Date of publication of application: **28.03.2012**
(21) Application number: 11165402.6
(22) Date of filing: 10.05.2011
(51) Int. Cl.: H01L 23/40, H01L 23/427, H01L 23/467

(54) **Heat dissipation device with multiple heat conducting pipes**

(30) Priority: 23.09.2010 TW 099132219
(71) Applicant: Chai, Kao-Teh, Taipei City 106 (CN)
(72) Inventor: Chai, Kao-Teh, Taipei City 106 (CN)
(74) Representative: Becker, Eberhard

(57) **Abstract**

A heat dissipation device with multiple heat conducting pipes is mounted on a heat-generating element disposed on a carrier. The heat dissipation device includes a heat dissipation base having at least one heat dissipation body, and a plurality of heat conducting pipes which are connected to the heat dissipation body and protrude outwards. The heat conducting pipes are used to dissipate the heat generated by the heat-generating element via heat conduction and natural convection with air, thus having a double heat dissipation effect.

## Description

### BACKGROUND

### Field of Invention

The present invention relates to a heat dissipation device. More specifically, the present invention relates to a heat dissipation device with multiple heat conducting pipes.

### Description of Related Art

While in operation, a heat-generating element such as a central processing unit (CPU) of a computer will generate high temperature and heat, and the heat has to be dissipated promptly for allowing the heat-generating element to continue to work normally.

Most of the conventional heat dissipating methods conduct heat dissipation by using a heat dissipation base and a heat dissipation fin contacting the heat-generating element. However, since the heat conduction or natural convection occurring in the conventional heat dissipating methods does not provide sufficient heat dissipation, its heat dissipation effect is not good enough. In order to lower the temperature of the heat-generating element and protect its performance and operation life, additional fan and motor are generally needed for conducting heat dissipation on the heat-generating element by forced convection.

However, the fan and motor have the disadvantages of high production cost, big volume (size), large power consumption and noise occurrence. Moreover, when the fan is operated to expel hot air and suck in cool air, the dusts in the air will be sucked in with the strong air flow and be adsorbed inside the main body (such as the computer) on which the heat-generating element is disposed, and then the dusts will be gradually accumulated on the rotating axle or blades of the fan, thus causing the fan to be seized and fail to work continuously, eventually resulting in the overheating breakdown of the heat-generating element.

On the other hand, another conventional heat dissipating method is a liquid cooling method, wherein a heat conducting pipe containing water or liquid is disposed to contact the heat-generating element, and a motor is used to drive the pump to circulate the water or liquid for achieving the purpose of dissipating the heat of the heat-generating element. However, the pump and motor also have the disadvantages of high production cost, big volume, large power consumption and noise occurrence.

In view of the foregoing reasons, the conventional heat dissipation devices have poor applicability.

### SUMMARY

An object of the present invention is to provide a heat dissipation device with multiple heat conducting pipes which is economically useful with excellent heat dissipation effect.

According to the aforementioned object, an aspect of the present invention is to provide a heat dissipation device with multiple heat conducting pipes, wherein the heat dissipation device is mounted above a heat-generating element disposed on a carrier, and comprises a heat dissipation base having at least one heat dissipation body; and a plurality of heat conducting pipe which are connected to the heat dissipation body and protrude outwards from the heat dissipation body. The heat conducting pipes are used to dissipate the heat generated by the heat-generating element via heat conduction and natural convection with air, thus having an excellent double heat dissipation effect.

According to one embodiment of the present invention, the heat conducting pipes are monolithically formed on the at least one heat dissipation body, thereby forming a connection structure between the heat conducting pipes and the heat dissipation body.

According to one embodiment of the present invention, there are a plurality of heat conductive cavities formed in the at least one heat dissipation body, and the heat conducting pipes are disposed in the heat conductive cavities respectively, thereby forming a connection structure between the heat conducting pipes and the heat dissipation body.

According to one embodiment of the present invention, the heat dissipation base is a hollow rectangular base with four wall-shaped heat dissipation bodies which are mutually connected, and the heat conducting pipes are monolithically formed on the wall-shaped heat dissipation bodies and protrude outwards from four respective sides of the wall-shaped heat dissipation bodies. Based on the four wall-shaped heat dissipation bodies and the hollow characteristic of the heat conducting pipes, the heat dissipation device can achieve the heat dissipation effect with heat conduction and natural convection.

According to one embodiment of the present invention, the heat dissipation base is a hollow rectangular base with four wall-shaped heat dissipation bodies which are mutually connected, and the heat conductive cavities are formed in the wall-shaped heat dissipation bodies, and the heat conducting pipes are disposed in the heat conductive cavities respectively and protrude outwards from four respective sides of the wall-shaped heat dissipation bodies. Based on the four wall-shaped heat dissipation bodies and the hollow characteristic of the heat conducting pipes, the heat dissipation device can achieve the heat dissipation effect with heat conduction and natural convection.

According to one embodiment of the present invention, the heat dissipation base is a U-shaped heat dissipation base with two wall-shaped heat dissipation bodies which are opposite to each other, and the heat conducting pipes are monolithically formed on the wall-shaped heat dissipation bodies and protrude outwards from two respective sides of the two wall-shaped heat dissipation bodies. Based on the two wall-shaped heat dissipation bodies and the hollow characteristic of the heat conducting pipes, the heat dissipation device can achieve the heat dissipation effect with heat conduction and natural convection.

According to one embodiment of the present invention, the heat dissipation base is a U-shaped heat dissipation base with two wall-shaped heat dissipation bodies which are opposite to each other, and the heat conductive cavities are formed in the wall-shaped heat dissipation bodies, and the heat conducting pipes are disposed in the heat conductive cavities respectively and protrude outwards from two respective sides of the wall-shaped heat dissipation bodies. Based on the two wall-shaped heat dissipation bodies and the hollow characteristic of the heat conducting pipes, the heat dissipation device can achieve the heat dissipation effect with heat conduction and natural convection.

According to one embodiment of the present invention, the heat dissipation base is a block-shaped heat dissipation base with a block-shaped heat dissipation body, and the heat conducting pipes are monolithically formed on the wall-shaped heat dissipation bodies and protrude outwards from two opposite sides of the block-shaped heat dissipation body respectively. Based on the block-shaped heat dissipation body and the hollow characteristic of the heat conducting pipes, the heat dissipation device can achieve the heat dissipation effect with heat conduction and natural convection.

According to one embodiment of the present invention, the heat dissipation base is a block-shaped heat dissipation base with a block-shaped heat dissipation body, and the heat conductive cavities are formed in the block-shaped heat dissipation body, and the heat conducting pipes are disposed in the heat conductive cavities respectively and protrude outwards from two opposite sides of the block-shaped heat dissipation body respectively. Based on the block-shaped heat dissipation body and the hollow characteristic of the heat conducting pipes, the heat dissipation device can achieve the heat dissipation effect with heat conduction and natural convection.

According to one embodiment of the present invention, the heat dissipation base is a disk-shaped heat dissipation base with a disk-shaped heat dissipation body, and the heat conducting pipes are monolithically arranged in an arrangement of at least one circle on the disk-shaped heat dissipation body, and the heat conducting pipes protrude upwards from the disk-shaped heat dissipation body respectively. Based on the disk-shaped heat dissipation body and the hollow characteristic of the heat conducting pipes, the heat dissipation device can achieve the heat dissipation effect with heat conduction and natural convection.

According to one embodiment of the present invention, the heat dissipation base is a disk-shaped heat dissipation base with a disk-shaped heat dissipation body, and the heat conductive cavities are formed in the disk-shaped heat dissipation body, and the heat conducting pipes are disposed in the heat conductive cavities which are arranged in at least one circle around the disk-shaped heat dissipation body, and the heat conducting pipes protrude upwards from the disk-shaped heat dissipation body respectively.

According to one embodiment of the present invention, each of the heat conducting pipes has a plurality of axial grooves formed in its interior wall, thereby reinforcing the strength of the heat conducting pipes, increasing the heat dissipation area, rapidly introducing heat flow and enhancing heat dissipation efficiency.

It is to be understood that both the foregoing general description and the following detailed description are examples, and are intended to provide further explanation of the invention as claimed.

### BRIEF DESCRIPTION OF THE DRAWINGS

These and other features, aspects, and advantages of the present invention will become better understood with regard to the following description, appended claims, and accompanying drawings where:
FIG. 1 is a schematic exploded view showing a heat dissipation device with multiple heat conducting pipes according to a first embodiment of the present invention;
FIG. 2 illustrates a schematic assembled view of the heat dissipation device shown in FIG. 1 and a schematic exploded view of the heat dissipation device and a carrier;
FIG. 3 illustrates a schematic cross-sectional view showing the assembly of the heat dissipation device and the carrier shown in FIG. 2;
FIG. 4 illustrates a schematic cross-sectional view showing the pipes of the heat dissipation device shown in FIG. 1;
FIG. 5 is a schematic exploded view showing a heat dissipation device with multiple heat conducting pipes according to a second embodiment of the present invention;
FIG. 6 illustrates a schematic assembled view of the heat dissipation device shown in FIG. 5 and a schematic exploded view of the heat dissipation device and a carrier;
FIG. 7 is a schematic exploded view showing a heat dissipation device with multiple heat conducting pipes according to a third embodiment of the present invention;
FIG. 8 illustrates a schematic assembled view of the heat dissipation device shown in FIG. 7 and a schematic exploded view of the heat dissipation device and a carrier;
FIG. 9 is a schematic exploded view showing a heat dissipation device with multiple heat conducting pipes according to a fourth embodiment of the present invention;
FIG. 10 illustrates a schematic assembled view of the heat dissipation device shown in FIG. 9 and a schematic exploded view of the heat dissipation device and a carrier; and
FIG. 11 is a cross-sectional diagram viewed along line A-A of the heat dissipation device shown in FIG. 10.

### DESCRIPTION OF THE PREFERRED EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

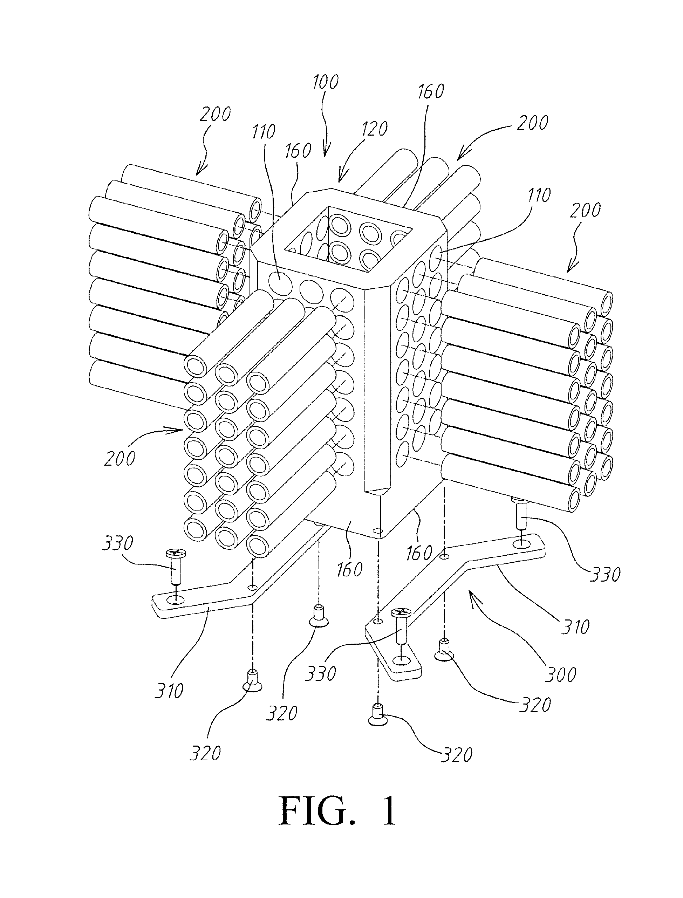

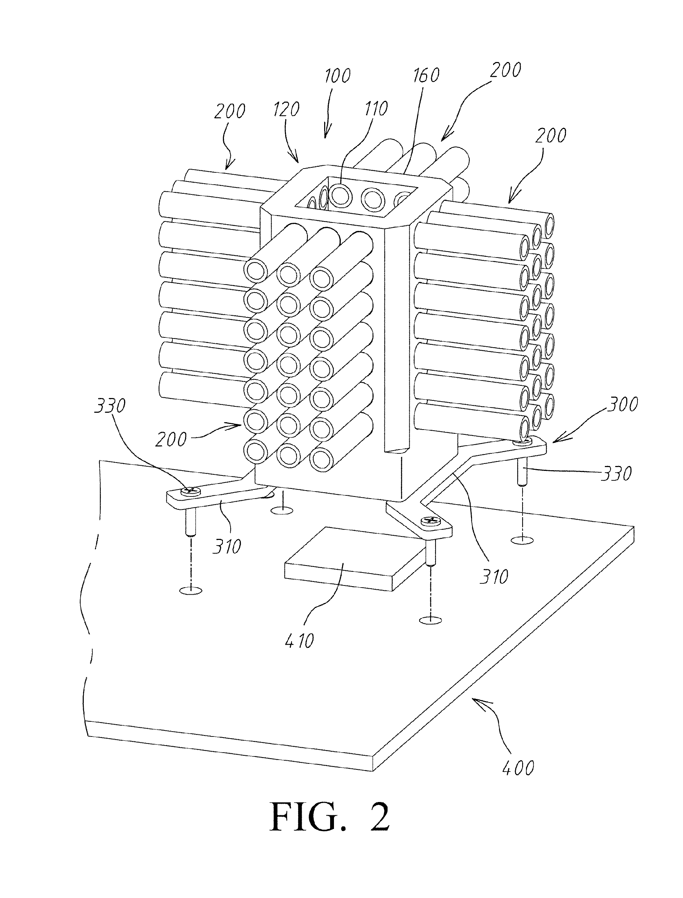

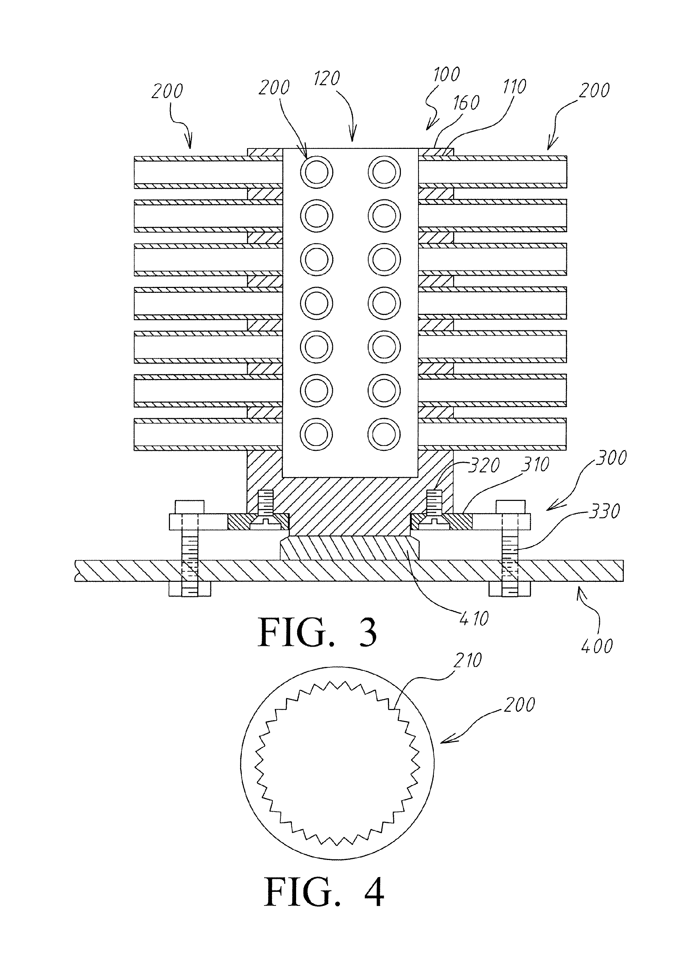

Referring to FIG. 1 to FIG. 4, FIG. 1 is a schematic exploded view showing a heat dissipation device with multiple heat conducting pipes according to a first embodiment of the present invention; FIG. 2 illustrates a schematic assembled view of the heat dissipation device shown in FIG. 1 and a schematic exploded view of the heat dissipation device and a carrier; FIG. 3 illustrates a schematic cross-sectional view showing the assembly of the heat dissipation device and the carrier shown in FIG. 2; and FIG. 4 illustrates a schematic cross-sectional view showing the pipes of the heat dissipation device shown in FIG. 1 As shown in the figures, according to the first embodiment of the present invention, a heat dissipation device with multiple heat conducting pipes, wherein the heat dissipation device is mounted above a heat-generating element 410 (such as a CPU) disposed on a carrier 400 (such as a circuit board). According to the first embodiment, the heat dissipation device includes a heat dissipation base 100 and a plurality of heat conducting pipes 200.

In practice, the heat dissipation base 100 is formed from a thermally conductive metal (such as aluminum, copper or their alloys) or non-metal (such as graphite). The heat dissipation base 100 can be formed in any geometrical shapes and has at least one heat dissipation body 160. For example, in the first embodiment, the heat dissipation base 100 is a hollow rectangular base 120 with four wall-shaped heat dissipation bodies 160 which are mutually connected. There are a plurality of heat conductive cavities 110 formed in the respective wall-shaped heat dissipation bodies 160.

Each of the heat conducting pipes 200 is a tubular body which is also formed from a thermally conductive metal (such as aluminum, copper or their alloys) or non-metal (such as graphite). The heat conducting pipes 200 are disposed in heat conductive cavities 110 of the wall-shaped heat dissipation bodies 160, and protrude outwards from four respective sides of the wall-shaped heat dissipation bodies 160.

The heat dissipation base 100 is fixed on a carrier 400 via a fixing unit 300. In practice, the fixing unit 300 includes two fixing brackets 310, a plurality of first fixing elements 320 and a plurality of second fixing elements 330, wherein the two fixing brackets 310 are located at two opposite positions of the bottom of the heat dissipation base 100; the fixing brackets 310 are fastened to the bottom of the heat dissipation base 100 via the first fixing elements 320, and are fastened to the carrier 400 via the second fixing elements 330, thereby making the bottom of the heat dissipation base 100 tightly contact the heat-generating element 410.

In operation, the heat generated by the heat-generating element 410 is directly conducted to the hollow rectangular base 120, and is dissipated through the four wall-shaped heat dissipation bodies 160 and the hollow heat conducting pipes 200. Based on the hollow characteristics of the four wall-shaped heat dissipation bodies 160 and the heat conducting pipes 200, the interior and exterior walls of the wall-shaped heat dissipation bodies 160 and those of the heat conducting pipes 200 can conduct heat dissipation at the same time, and the temperature differences between the internal and the external of the heat conducting pipes 200 also cause natural convection, thereby achieving excellent heat dissipation effect.

In practice, each of the heat conducting pipes 200 further may have a plurality of axial grooves 210 formed in its interior wall for reinforcing the strength of the heat conducting pipes 200 for absorbing the changes thanks to thermal expansion or condensation of the heat conducting pipes 200 in heat conduction, thereby increasing heat dissipation area and rapidly introducing thermal flow, thus promoting heat dissipation efficiency.

Each of the heat conducting pipes 200 also can be monolithically formed on the wall-shaped heat dissipation bodies 160, and has the same operation efficacy described above.

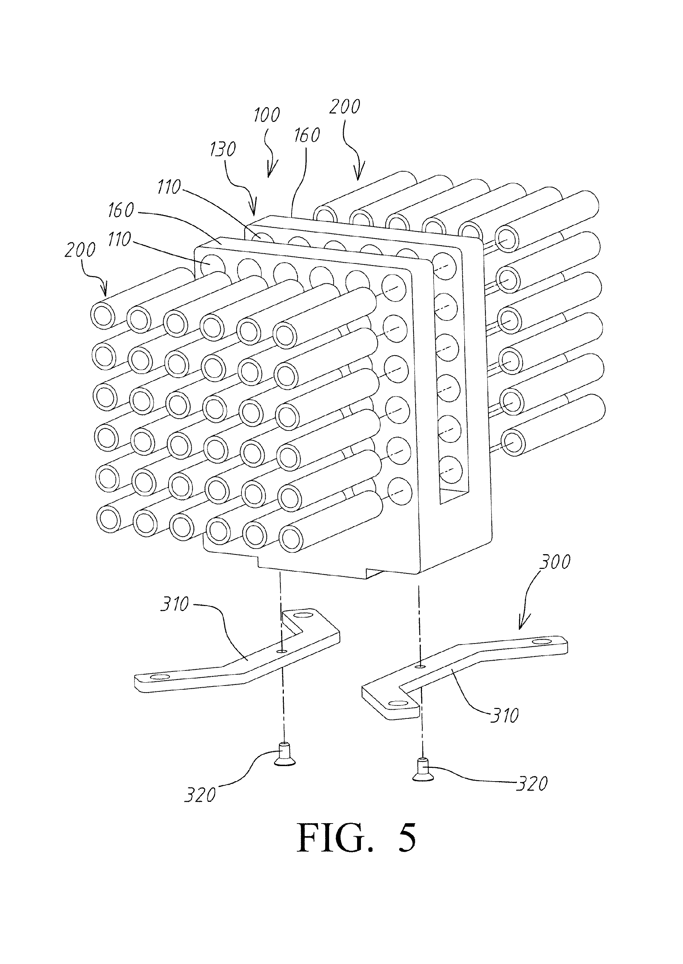

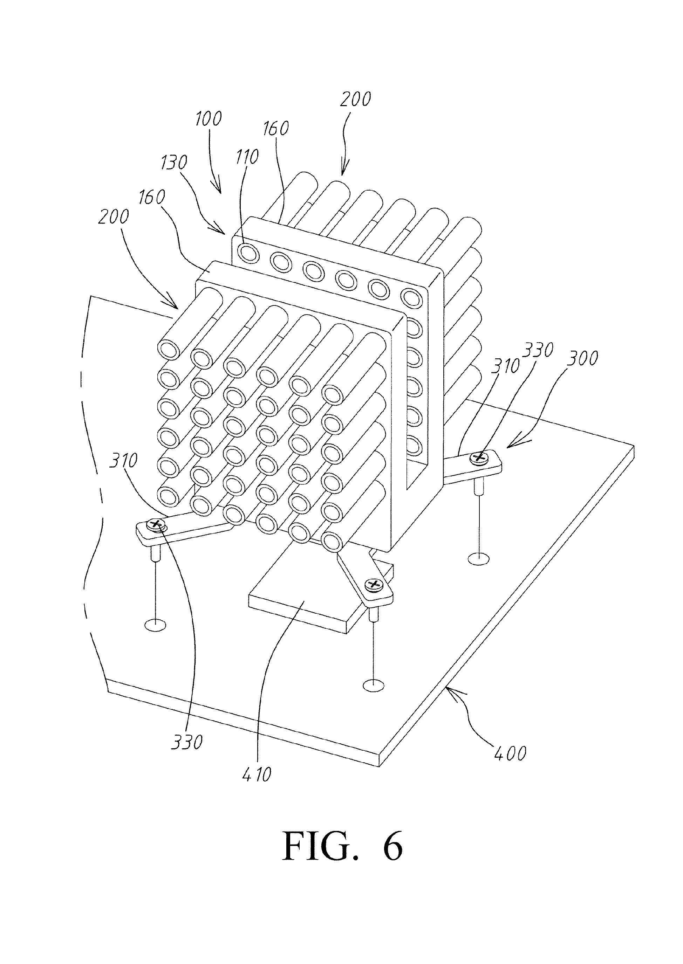

Referring to FIG. 5 and FIG. 6, FIG. 5 is a schematic exploded view showing a heat dissipation device with multiple heat conducting pipes according to a second embodiment of the present invention; and FIG. 6 illustrates a schematic assembled view of the heat dissipation device shown in FIG. 5 and a schematic exploded view of the heat dissipation device and a carrier. As shown in the figures, according to the second embodiment, the heat dissipation device includes a heat dissipation base 100 and a plurality of heat conducting pipes 200, and further includes a fixing unit 300. The heat conducting pipes 200 and the fixing manner between the fixing unit 300 and the carrier 400 are the same for the first and second embodiments, but the heat dissipation base 100 of the second embodiment is a U-shaped heat dissipation base 130 with two wall-shaped heat dissipation bodies 160 which are opposite and connected to each other. There are a plurality of heat conductive cavities 110 formed in the wall-shaped heat dissipation bodies 160, and the heat conducting pipes 200 are disposed in the heat conductive cavities 110 respectively and protrude outwards from two respective sides of the wall-shaped heat dissipation bodies 160.

In operation, the heat generated by the heat-generating element 410 is directly conducted to the U-shaped heat dissipation base 130, and is dissipated through the two wall-shaped heat dissipation bodies 160 and the hollow heat conducting pipes 200. Based on the hollow characteristics of the two wall-shaped heat dissipation bodies 160 and the heat conducting pipes 200, the interior and exterior walls of the wall-shaped heat dissipation bodies 160 and those of the heat conducting pipes 200 can conduct heat dissipation at the same time, and the temperature differences between the internal and the external of the heat conducting pipes 200 also cause natural convection, thereby achieving excellent heat dissipation effect.

In practice, each of the heat conducting pipes 200 also can be monolithically formed on the wall-shaped heat dissipation bodies 160, and has the same operation efficacy described above.

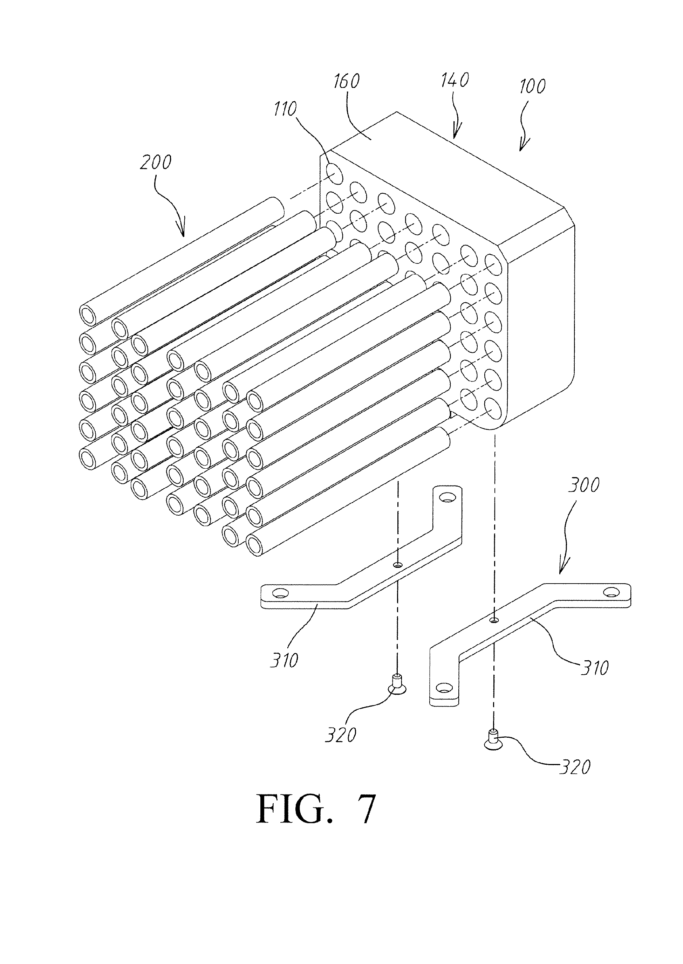

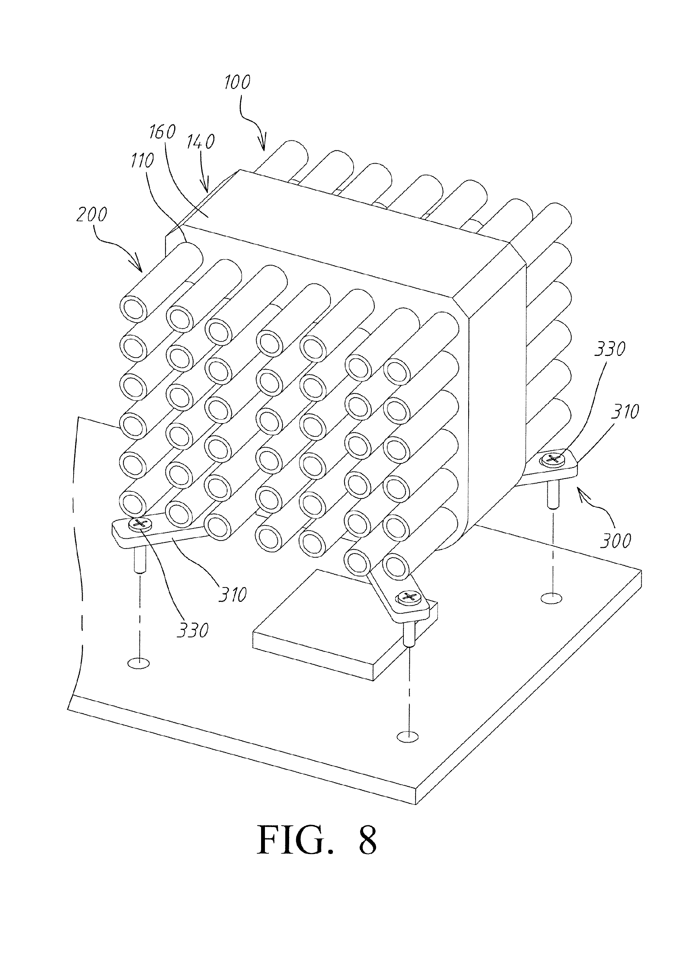

Referring to **FIG.** 7 and FIG. 8, FIG. 7 is a schematic exploded view showing a heat dissipation device with multiple heat conducting pipes according to a third embodiment of the present invention; and FIG. 8 illustrates a schematic assembled view of the heat dissipation device shown in FIG. 7 and a schematic exploded view of the heat dissipation device and a carrier. As shown in the figures, according to the third embodiment, the heat dissipation device includes a heat dissipation base 100 and a plurality of heat conducting pipes 200, and further includes a fixing unit 300. The heat conducting pipes 200 and the fixing manner between the fixing unit 300 and the carrier 400 are the same for the first and third embodiments, but the heat dissipation base 100 of the third embodiment is a block-shaped heat dissipation base 140 with a block-shaped heat dissipation body 160. There are a plurality of heat conductive cavities 110 formed in the block-shaped heat dissipation body 160, and the heat conducting pipes 200 are disposed in the heat conductive cavities 110 respectively and protrude outwards from two opposite sides of the block-shaped heat dissipation body 160 respectively.

In operation, the heat generated by the heat-generating element 410 is directly conducted to the block-shaped heat dissipation base 140, and is dissipated through the block-shaped heat dissipation bodies 160 and the hollow heat conducting pipes 200. Based on the hollow characteristic of the heat conducting pipes 200, the interior and exterior walls of the heat conducting pipes 200 can conduct heat dissipation at the same time, and the temperature differences between the internal and the external of the hollow heat conducting pipes 200 also cause natural convection, thereby achieving excellent heat dissipation effect.

In practice, each of the heat conducting pipes 200 also can be monolithically formed on the wall-shaped heat dissipation bodies 160, and has the same operation efficacy described above.

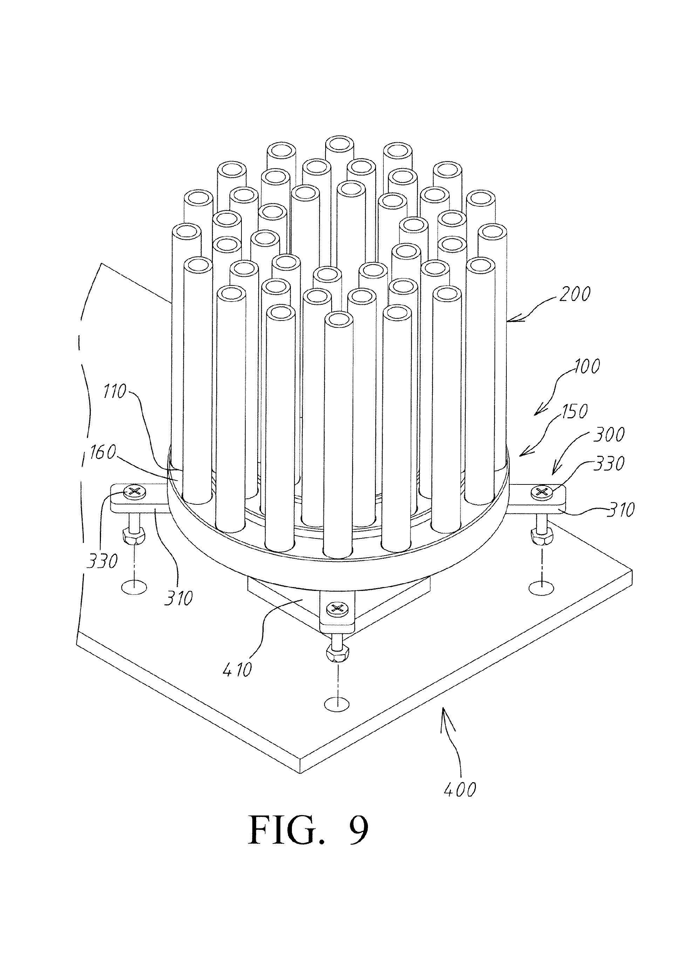

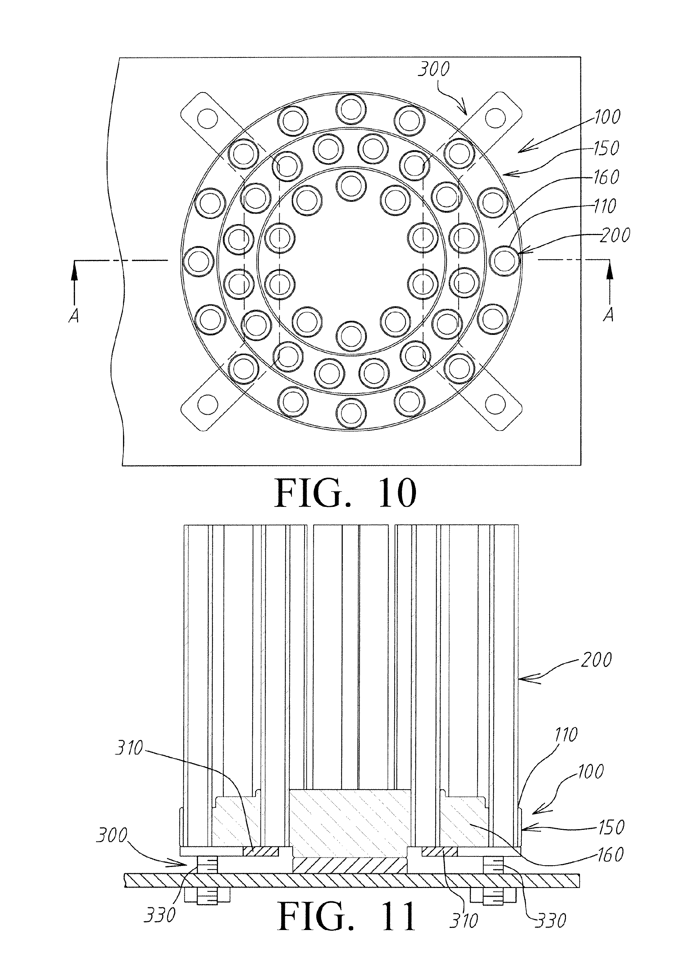

Referring to FIG. 9 to FIG. 11, FIG. 9 is a schematic exploded view showing a heat dissipation device with multiple heat conducting pipes according to a fourth embodiment of the present invention; FIG. 10 illustrates a schematic assembled view of the heat dissipation device shown in FIG. 9 and a schematic exploded view of the heat dissipation device and a carrier; and FIG. 11 is a cross-sectional diagram viewed along line A-A of the heat dissipation device shown in FIG. 10. As shown in the figures, according to the fourth embodiment, the heat dissipation device includes a heat dissipation base 100 and a plurality of heat conducting pipes 200, and further includes a fixing unit 300. The heat conducting pipes 200 and the fixing manner between the fixing unit 300 and the carrier 400 are the same for the first and fourth embodiments, but the heat dissipation base 100 of the fourth embodiment is a disk-shaped heat dissipation base 140 with a disk-shaped heat dissipation body 160. There are a plurality of heat conductive cavities 110 formed in an arrangement of three circles on the disk-shaped heat dissipation body 160, and the heat conducting pipes 200 are disposed in the heat conductive cavities 110 and protrude upwards from the disk-shaped heat dissipation body 160 respectively.

In operation, the heat generated by the heat-generating element 410 is directly conducted to the disk-shaped heat dissipation base 150, and is dissipated through the disk-shaped heat dissipation bodies 160 and the hollow heat conducting pipes 200. Based on the hollow characteristic of the heat conducting pipes 200, the interior and exterior walls of the heat conducting pipes 200 can conduct heat dissipation at the same time, and the temperature differences between the internal and the external of the hollow heat conducting pipes 200 also cause natural convection, thereby achieving excellent heat dissipation effect.

In practice, each of the heat conducting pipes 200 also can be monolithically formed on the wall-shaped heat dissipation bodies 160, and has the same operation efficacy described above.

According to the above embodiments of the present invention, the dissipation device with multiple heat conducting pipes dissipates the heat generated by the heat-generating element by using heat conduction and natural convection via the heat conducting pipes, thus having an excellent double heat dissipation effect; and further, does not need additional fan and motor, thus avoiding the problems of high production cost, big volume, large power consumption and noise occurrence. Accordingly, the object of the present invention can be achieved.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A heat dissipation device mounted above a heat-generating element disposed on a carrier, the heat dissipation device comprising:
a heat dissipation base having at least one heat dissipation body; and
a plurality of heat conducting pipes which are connected to the heat dissipation body and protrude outwards from the heat dissipation body.

2. The heat dissipation device as claimed in claim 1, wherein the heat conducting pipes are monolithically formed on the at least one heat dissipation body.

3. The heat dissipation device as claimed in claim 1, wherein there are a plurality of heat conductive cavities formed in the at least one heat dissipation body, and the heat conducting pipes are disposed in the heat conductive cavities respectively.

4. The heat dissipation device as claimed in claim 2, wherein the heat dissipation base is a hollow rectangular base with four wall-shaped heat dissipation bodies which are mutually connected, and the heat conducting pipes are monolithically formed on the wall-shaped heat dissipation bodies and protrude outwards from four respective sides of the wall-shaped heat dissipation bodies.

5. The heat dissipation device as claimed in claim 3, wherein the heat dissipation base is a hollow rectangular base with four wall-shaped heat dissipation bodies which are mutually connected, and the heat conductive cavities are formed in the wall-shaped heat dissipation bodies, and the heat conducting pipes are disposed in the heat conductive cavities respectively and protrude outwards from four respective sides of the wall-shaped heat dissipation bod ies.

6. The heat dissipation device as claimed in claim 2, wherein the heat dissipation base is a U-shaped heat dissipation base with two wall-shaped heat dissipation bodies which are opposite to each other, and the heat conducting pipes are monolithically formed on the wall-shaped heat dissipation bodies and protrude outwards from two respective sides of the wall-shaped heat dissipation bodies.

7. The heat dissipation device as claimed in claim 3, wherein the heat dissipation base is a U-shaped heat dissipation base with two wall-shaped heat dissipation bodies which are opposite to each other, and the heat conductive cavities are formed in the wall-shaped heat dissipation bodies, and the heat conducting pipes are disposed in the heat conductive cavities respectively and protrude outwards from two respective sides of the wall-shaped heat dissipation bodies.

8. The heat dissipation device as claimed in claim 2, wherein the heat dissipation base is a block-shaped heat dissipation base with a block-shaped heat dissipation body, and the heat conducting pipes are monolithically formed on the wall-shaped heat dissipation bodies and protrude outwards from two opposite sides of the block-shaped heat dissipation body respectively.

9. The heat dissipation device as claimed in claim 3, wherein the heat dissipation base is a block-shaped heat dissipation base with a block-shaped heat dissipation body, and the heat conductive cavities are formed in the block-shaped heat dissipation body, and the heat conducting pipes are disposed in the heat conductive cavities respectively and protrude outwards from two opposite sides of the block-shaped heat dissipation body respectively.

10. The heat dissipation device as claimed in claim 2, wherein the heat dissipation base is a disk-shaped heat dissipation base with a disk-shaped heat dissipation body, and the heat conducting pipes are monolithically arranged in an arrangement of at least one circle on the disk-shaped heat dissipation body, and the heat conducting pipes protrude upwards from the disk-shaped heat dissipation body respectively.

11. The heat dissipation device as claimed in claim 3, wherein the heat dissipation base is a disk-shaped heat dissipation base with a disk-shaped heat dissipation body, and the heat conductive cavities are formed in an arrangement of at least one circle on the disk-shaped heat dissipation body, and the heat conducting pipes are disposed in the heat conductive cavities, and the heat conducting pipes protrude upwards from the disk-shaped heat dissipation body respectively.

12. The heat dissipation device as claimed in claim 1, wherein each of the heat conducting pipes has a plurality of axial grooves formed in its interior wall.
